# EUROPEAN PATENT APPLICATION

(11) **EP 4 369 096 A1**
(43) Date of publication of application: **15.05.2024**
(21) Application number: 22206728.2
(22) Date of filing: 10.11.2022
(51) Int. Cl.: G03F 1/36

(54) **METHOD AND DEVICE FOR GENERATING PATTERN DENSITY DATA**

(71) Applicant: MYCRONIC AB, 183 03 Täby (SE)
(72) Inventor: Ihrén, Fredric, 18745 Täby (SE)
(74) Representative: AWA Sweden AB

(57) **Abstract**

A method for determining pattern density data for a pattern to be printed using a mask printing device is disclosed. Vector data describing the pattern to be printed are received and the vector data are rasterized to produce rasterized data describing the pattern to be printed, wherein the rasterized data comprise a grid of pixels, wherein each pixel is associated with a respective exposure value. A plurality of subsets of pixels of the grid of pixels are defined, wherein each subset of pixels corresponding to a subarea of the pattern to be printed, and the pattern density data are determined from the rasterized data, wherein the pattern density data comprises, for each subset of pixels of the grid of pixels, a density value calculated based on the exposure values of the subset of pixels.

## Description

### Technical field

The present invention generally relates to the field of generating a pattern density data for photomask preparation.

### Background

A photomask is an image transferring tool. The photomask comprises a transparent substrate, such as glass or fused silica (fused quartz), which has an opaque coating on one surface into which a microscopic pattern has been etched, leaving some regions transparent and others opaque. The transparent regions allow light to pass through, which transfers the pattern from the photomask onto another substrate, such as a silicon wafer, which has been coated with a photosensitive material called photo resist. They are commonly used in photolithography and the production of integrated circuits (ICs) in particular. The semiconductor industry is not the only industry to make use of and benefit from photomask technology. Photomasks are used extensively to produce devices for consumer products, computers, printers and other peripherals, military products, automotive products, medical and biomedical products. One of the several application areas of photomasks is the display industry.

In the area of display industry, technological development is continuing at a rapid pace, with more and smaller pixels. The trend is heading in the direction of more complex display technologies such as AMOLED, which means that both additional photomasks and more complex photomasks are needed in order to manufacture displays.

A photomask can be compared to a photo negative. A pattern on the photomask is written by a mask writer and transferred to the end product, for e.g., silicon wafer, by a lithographic process. The pattern to be written on the photomask is provided as an input to the mask writer. An incoming data for mask printing is a vector data, e.g., group of polygons. The vector data is usually generated using CAD tools. Further, the vector data may be input in a hierarchical vector format such as GDSII, MIC or OASIS formats. With the greater demand for higher resolution of photomasks, a pattern density data is often used to adapt the vector data in order to enhance the printing. Pattern density assists in compensating for the errors that may be introduced in the developing process of photomasks by developer loading or by the exposure that may leak between pixels within high density areas while printing photomasks. The vector data is used to generate the pattern density data for a pattern to be printed on the photomask which are provided to a mask writer for printing the pattern on the photomask together with the vector data. However, one problem with the prior art is high complexity in calculating the pattern density data.

### Summary

The inventor realized the problem with prior art that high complexity in calculating the pattern density data from the vector pattern data is particularly because of the complex algorithms for manipulating and analyzing vector data. This can lead to intensive processing requirements, particularly when dealing with large datasets.

Thus, it would be advantageous to achieve a method and a device overcoming, or at least alleviating, the above-mentioned drawback. In particular, it would be desirable to enable efficient generation of pattern density data from incoming vector data. The inventor has realized that this can be achieved by first transforming the vector data to rasterized data. The rasterized data may then be used to effectively generate pattern density data to be used for writing photomasks, for example, writing a photomask for manufacturing high quality displays. Thereby the complexity in calculating of pattern density data is reduced. Also, where the raster data is already available, like in mask writers, it is efficient to use raster data for calculating pattern density data. Furthermore, large memory storage requirement for handling complex vector data when calculating pattern density can be reduced. It is clear to the person skilled in art that the processing applied to the raster data to generate pattern density data for use by mask writer of photomask, may also be applied to multipurpose writers, semiconductor mask writers and other pattern generators. To better address one or more of these concerns, a method, a device and a system having the features defined in the independent claim is provided. Preferable embodiments are defined in the dependent claims.

Hence, according to a first aspect, a method is provided for determining pattern density data for a pattern to be printed using a mask printing device. The method comprises receiving a vector data describing the pattern to be printed. The vector data is rasterized to produce a rasterized data describing the pattern to be printed. The rasterized data further comprises a grid of pixels. Each pixel in the grid of pixels is associated to a respective exposure value. A plurality of subsets of pixels of the grid of pixels is defined. Each subset of pixels corresponds to a subarea of the pattern to be printed. The pattern density data are then determined from the rasterized data. Determining the pattern density data comprises, for each subset of pixels of the grid of pixels, calculating a density value based on the exposure values of the subset of pixels.

Several advantages are associated with the present invention. Firstly, it is less complex to handle the rasterized data represented in grid of pixels than the vector data where information is represented by a collection of geometrical objects, for example, using one or more co-ordinate points, lines or polygons, to represent longitudes and latitudes in vector data. Secondly, the format of the raster data having grid of the pixels, where pixels are organized into rows and columns is more suitable for adapting exposure values in relation to pattern to be printed. Each pixel in the grid of pixels is associated with a respective exposure value. The exposure value is calculated for each pixel in order to achieve the desired pattern at printing. Further, it may be easy to process the raster data, i.e. exposure values of pixels in the raster data for processing by processing devices, for example, for calculating pattern density data over a subset of pixels in the raster data. Thirdly, a mask writer is typically already arranged to produce rasterized data from the vector data. It may be time effective and less complex to use the available raster data for calculating pattern density data.

The term vector data may refer to the representation of spatial data as a collection of geometric objects such as points, lines, polygons, arcs, circles, etc.

The term raster data or rasterized data comprises a matrix/grid of cells or pixels organized into rows and columns or a grid where each cell contains a value representing information. The dimension of the pixels can be as large or as small as needed to represent the features of the pattern to be printed and/or to determine pattern density data. The cell size or pixel size determines how coarse or fine the patterns in the raster data will appear. The smaller the pixel size, the smoother or more detailed the raster will be. However, the greater the number of pixels, the longer it will take to process, and it will increase the demand for storage space. On the other hand, if a cell size is too large, information may be lost, or subtle patterns may be obscured.

The term exposure value of each pixel in the grid of pixels may refer to setting a laser intensity for each respective pixel and the time for which the pixel is exposed to a laser. Sometimes the intensity is defined as a relative intensity where 100% is the intensity used for a fully exposed pixel according to the pattern to be printed. Pixels may also be exposed with relative intensity < 100%, e.g. depending on how much of the pixel is to be exposed as defined by the pattern to be printed. The relative laser intensity may also be calculated based on the exposure values of the pixel itself and neighbouring pixels.

The term pattern density data is used to describe the density of the patterns to be printed using the mask printing device. The pattern density data may be determined for subareas of the pattern to be printed using the mask printing device. The pattern density is calculated for each subset of pixels of the grid of pixels based on the exposure values of the subset of pixels.

In the step of determining the pattern density data, the density value for each subset of pixels may be the average i.e. mean, mode or median of the exposure values of the respective subset of pixels. Since the rasterized data is already available in the mask writer and is easily accessible, the average of the exposure values of the pixels in the subsets of pixels may be easily calculated. An advantage of having the pattern density average over the subset of pixels is that it helps in calculating pattern density data that provides a good adaptation of the pattern represented by the vector data by adapting for any leakage to the neighbouring pixels while printing to achieve a good result in a printed mask.

In the step of defining the plurality of subsets of pixels, each subset of pixels may corresponds to a respective rectangular subarea of the pattern to be printed. A skilled person in art would understand that, in some cases, it is also possible to have all sides of the rectangular subarea having the same dimensions, i.e. the subareas each being square shaped. The plurality of subsets of pixels may be defined such that each pixel in the grid of pixels is included in at least one of the subsets of pixels. In other words, it is possible to have a pixel in the grid of pixels to be included in more than one subset of pixels. An advantage of having subset of pixels corresponding to a respective rectangular or square subarea of the pattern to be printed is that it is easy to apply the pattern density data to adapt rasterised data for printing.

The step of defining the plurality of subsets of pixels, may further include having each subset of pixels corresponding to a subarea of a printed pattern having an area in the range of 0.01 - 4 mm². As each pixel in the grid of pixels of the raster data, is part of at least a subset of pixels of the plurality of subsets of pixels. Each pixel of the plurality of subsets of pixels in the grid of pixels is associated with a respective exposure value. The pattern density is calculated for each subset of pixels independently, thus reducing complexity and memory storage requirements. For the same resolution, the subset of pixels corresponding to a subarea of a printed pattern having a larger area, for example, 4 mm² is less complex in calculating pattern density than a subarea of a printed pattern having a smaller area, for example, 0.01 mm². Therefore, reducing raster data into subsets of pixels is an efficient way of calculating the pattern density. Usually, the subset of pixels corresponding to a subarea of a printed pattern, wherein the subarea having sides in the range of 0.5 - 1 mm is more preferred.

The vector data can be rasterized to produce rasterized data having a resolution lower than a resolution of rasterized data required to achieve an intended exposed resolution of the pattern to be printed. The lower resolution raster data could further reduce the complexity of calculating pattern density data by reducing the number of data points, i.e. pixels, for which the exposure value needs to be calculated. Reduced number of pixels may further reduce the number of subsets of pixels used to calculate the pattern density. This may result in further reducing the cost of storing and processing the raster data.

For example, the method for determining pattern density data may be adapted to dividing the vector data into a number of portions of vector data, each describing a respective portion of the pattern to be printed. The step of rasterizing the vector data comprises rasterizing each of the number of portions of vector data separately to produce a corresponding number of portions of rasterized data. Each portion of rasterized data describes a corresponding portion of the pattern to be printed. Further, each of the corresponding number of portions of the rasterized data comprises a respective portion of the grid of pixels, wherein each pixel is associated to a respective exposure value. Each of the portions of rasterized data can be further processed to calculate a pattern density equivalently as discussed earlier. The advantage of dividing the vector data into number of portions of vector data is that the format of the density data retrieved is then adapted to the way that the rasterised data is used in some mask writer. By having the density data described for each portion of vector data (e.g. stripe of vector data) we can apply the density data easily to respective portion the rasterized data for printing the vector portion/stripe.

Dividing the vector data into a number of portions of vector data and rasterizing each of the number of portions of vector data separately to produce a corresponding number of portions of rasterized data may help in determining the density data in a format suitably adapted to the way that the rasterized data is used in some mask writer. In other words, by having the density data described for each portion (i.e., stripe) of vector data, the density data may be applied easily to the rasterized data for printing the stripe.

According to a second aspect, a method is provided for deriving adapted rasterized data describing a pattern to be printed using a mask printing device. The method comprises receiving the rasterized data, determining pattern density data for the pattern according to the method of any of the first aspect, and deriving the adapted rasterized data describing the pattern to be printed from the received rasterized data using the determined pattern density data.

The method of the second aspect may further include additional features corresponding to the additional features described in relation to the method of the first aspect.

According to a third aspect, a computer readable storage medium is provided comprising computer readable instructions which, when executed by a device having processing capability, causes the device to carry out the method of the first or second aspect.

The computer readable storage medium of the third aspect may further include additional features corresponding to the additional features described in relation to the method of the first or second aspect.

The computer readable storage medium of the third aspect may for example be a non-transitory computer readable media.

According to a fourth aspect, a computer program is provided comprising computer readable instructions which, when executed by a device having processing capability, causes the device to carry out the method of the first or second aspect.

The computer program of the fourth aspect may further include additional features corresponding to the additional features described in relation to the method of the first or second aspect.

According to a fifth aspect, a method is provided for producing a photomask according to a pattern in a mask printing device. The method comprising deriving adapted rasterized data describing the pattern to be printed according to the method of the second aspect. Thereby, producing the photomask using the adapted rasterized data describing the pattern to be printed.

The method of the fifth aspect may further include additional features corresponding to the additional features described in relation to the method of the second aspect.

According to a sixth aspect, a computer readable storage medium comprising computer readable instructions which, when executed by a system for printing a pattern comprising a mask printing device and a processor, causes the system to carry out the method of the fifth aspect.

The computer readable storage medium of the sixth aspect may further include additional features corresponding to the additional features described in relation to the method of the fifth aspect.

The computer readable storage medium of the sixth aspect may for example be a non-transitory computer readable media.

According to a seventh aspect, a computer program comprising computer readable instructions which, when executed by a system for printing a pattern comprising a mask printing device and a processor, causes the system to carry out the method of the fifth aspect.

The computer program of the seventh aspect may further include additional features corresponding to the additional features described in relation to the method of the fifth aspect.

According to an eighth aspect, a system for printing pattern in a mask printing device. The system comprises a mask printing device, a processor, and a computer readable storage medium. The computer readable storage medium comprises computer readable instructions which, when executed by the processor having processing capability, causes the processor to carry out the method of the first or second aspect.

The system of the eighth aspect may further include additional features corresponding to the additional features described in relation to the method of the first aspect.

### Brief description of the drawings

These and other aspects will now be described in more detail with reference to the appended drawings showing embodiments.
Figure 1a, 1b, 1c and 1d show vector data, raster data, and a plurality of subsets of pixels in raster data, respectively, wherein each relating to the pattern to be printed;
Figure 2 shows a system for printing a pattern using raster data;
Figure 3 shows a flowchart illustrating a method for determining pattern density data for a pattern to be printed in a mask printing device;
Figure 4 shows the vector data divided into a number of portions of vector data, i.e., fractured data;
Figure 5 shows how the pattern density data for each of the plurality of subset of pixels described in relation to Fig. 1 may be used to adjust the deviations in patterns, that may occur during the printing and development of photomasks;
Figure 6 shows a method for deriving adapted rasterized data describing a pattern to be printed using a mask printing device;
Figure 7 shows a method for producing a photomask according to a pattern to be printed using a mask printing device.

All the figures are schematic, not necessarily to scale, and generally only show parts which are necessary in order to elucidate the embodiments, wherein other parts may be omitted or merely suggested. Like reference numerals refer to like elements throughout the description.

### Detailed description

The present aspects will now be described more fully hereinafter with reference to the accompanying drawings, in which currently preferred embodiments are shown. This invention may, however, be embodied in many different forms and should not be construed as limited to the embodiments set forth herein; rather, these embodiments are provided for thoroughness and completeness, and fully convey the scope of the present aspects to those skilled in art.

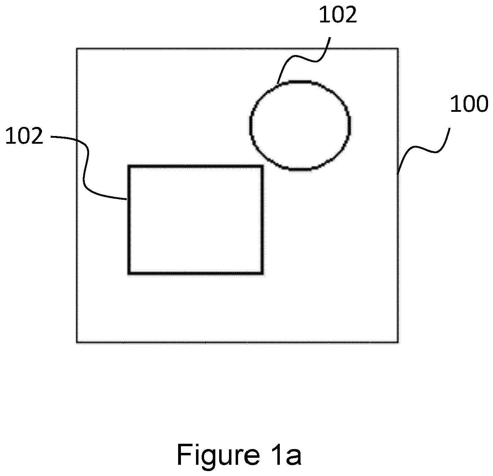

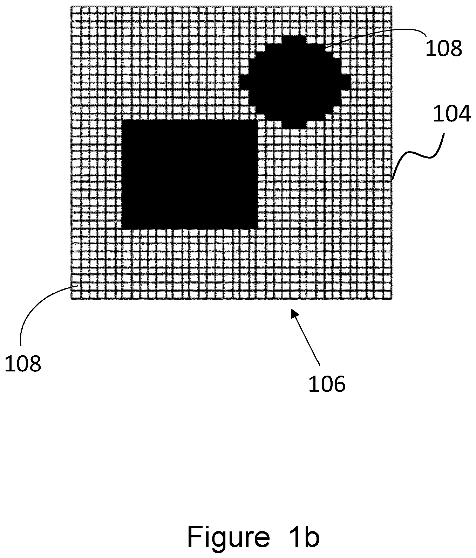

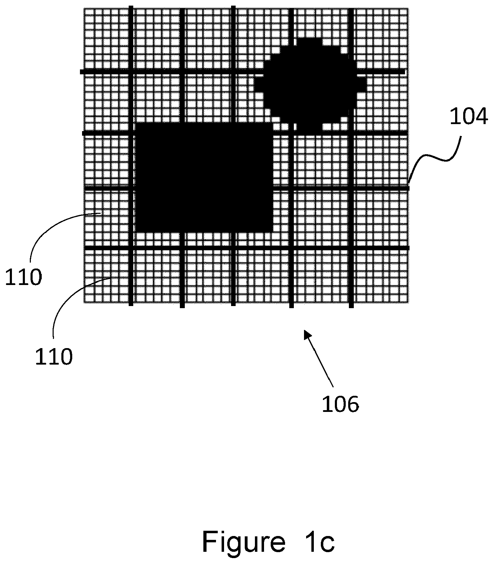

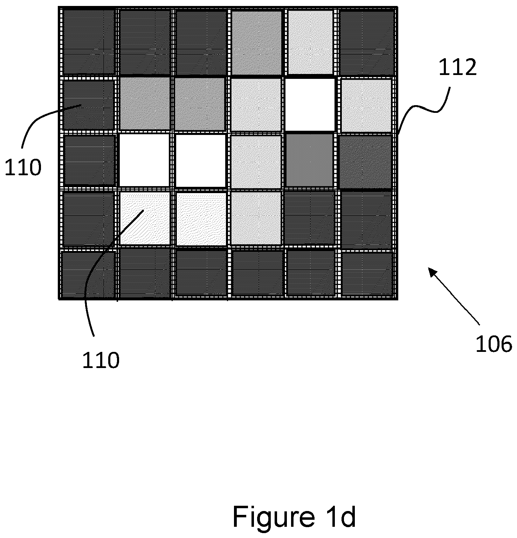

Referring to figure 1a, there is shown vector data 100 that relates to a pattern 102 to be printed. However, the pattern 102 shown in the figure is only for illustration purposes and does not reflect a typical pattern for printing. Figure 1b shows raster data 104, obtained by rasterizing the vector data 100 shown in figure 1a. The raster data 104 comprises a grid of pixels 106. Each pixel 108 in the grid of pixels 106 is associated with a respective exposure value depending on the pattern to be printed. The exposure value of each pixel 108 in the grid of pixels 106 may refer to setting a laser intensity for each respective pixel and the time for which the pixel is exposed to a laser. A plurality of subsets of pixels 110 are defined of the grid of pixels 106 in the raster data 104, as shown in figure 1c. Each subset of pixels of the plurality of subsets of pixels 110, corresponds to a respective rectangular subarea of the pattern to be printed. The rectangular subarea of the pattern to be printed may also be a square subarea or a subarea in any other shape corresponding to the subset of pixels 110 of the pattern to be printed. The plurality of subsets of pixels 110 may be defined such that each pixel 108 in the grid of pixels 106 is included in at least one of the subsets of pixels 110. In other words, it is possible to have a pixel 108 in the grid of pixels 106 to be included in more than one subset of pixels 110. The plurality of the subsets of pixels 110 are used to determine the pattern density data from the rasterized data 104. Pattern density data 112 is calculated for each subset of pixels 110 based on the exposure value of the pixels 108 in the respective subset of pixels 110. The pattern density data 112 for each subset of pixels 110 may be determined as the average of the exposure values of the pixels 108 in the respective subsets of pixels 110. As shown in figure 1d, pattern density data 112 may correspond to the density of the patterns in the subarea of the pattern to be printed, corresponding to the subset of pixels 110 in the mask printing device. The pattern density 112 calculated for each subset of pixels 110 is constant for the pixels 108 in the subset of pixels 110. The subareas where the pattern density is highest, or in other words, where the pixels are having maximum exposure are indicated in white. On the other hand, the subareas having very low, or no exposure are indicated in dark, e.g. black. While the subareas having intermediate exposure increases in brightness from dark to white on the grey scale with an increase in pattern density or exposure in the respective subarea. In other words, pattern density 112 of the subset of pixels 110 may also be expressed as a measure of how many of the pixels 108 in the subarea are exposed and to what extent. The pattern density data 112 are then provided to a mask writer (mask printing device). In some of the mask writers the process of determining the pattern density may be performed within the mask writer. Thus, it is possible that in some of the embodiments, the steps of processing the vector data, for example, rasterizing the vector data, determining pattern density from raster data, or further, could be performed in the mask writer with an in-built processor.

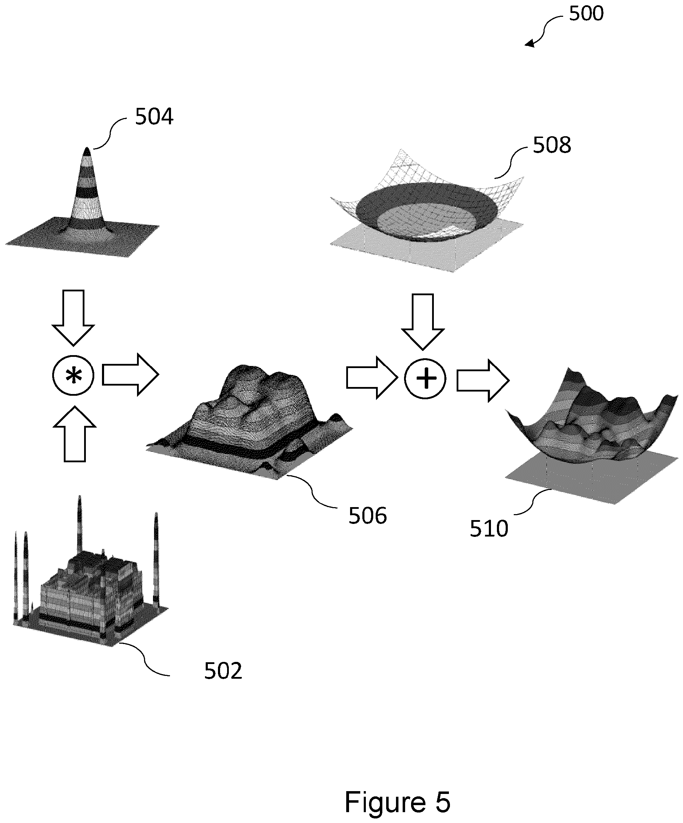

The calculated pattern density 112 may be used to correct the exposure value of pixel 108 in the grid of pixels 106. The requirement to correct the exposure values of pixel 108 in the grid of pixels 106 may arise primarily due to chemical process that may occur during the development of photomasks. The chemical process in the development of photomasks may result in chemical flare or developer loading. The secondary requirement to correct the exposure values of pixel 108 maybe due to stray light effects that may occur while exposing any pixel. However, for the size of pixels in the subareas we are aiming at are more influenced by chemical processes. Both the chemical processes, i.e., chemical flare or developer loading may cause deviations in pattern size of the pattern to be printed on a photomask. A long range proximity effect, i.e. chemical flare may occur in chemically amplified resists that is related to the development process of a photomask. One potential source of this effect is acid volatility, where acid is presumed to redeposit during exposure which causes chemical flare. Whereas, developer loading may refer to the impact of local depletion of a developer in highly exposed regions. Chemical flare and developer loading are primary source of errors that are introduced during the development of photomasks and is known for example from a paper titled "A method to characterize pattern density effects: chemical flare and developer loading", Proceedings Volume 7639, Advances in Resist Materials and Processing Technology XXVII; 76392S (2010). A skilled person would understand that the effect of chemical processes in mask lithography is similar to that in wafer lithography. Further, the stray light effect may be described as the leaked exposure, that is, an unwanted exposure caused by stray light. Another term used to measure this unwanted exposure is energy spread. No optical surface can be completely ideal. The illumination for example, from a Gaussian laser source may spread at each optical surface or device in the optical path due to optical imperfections. Therefore, when the neighbouring pixels are exposed, stray light from neighbouring pixels can contribute to the exposure of the pixel 108. The total sum of the added up combination of all the unwanted spread of light and energy is the stray light profile or energy spread profile of the mask writer or device. The exposure value of the pixels in the grid of pixels 106 may be affected by for example, any of the above mentioned chemical process or stray light affect which could be adjusted by the calculated pattern density 112. The process of adjusting the exposure value of the pixels using the calculated pattern density 112 is further explained in detail using Fig. 5.

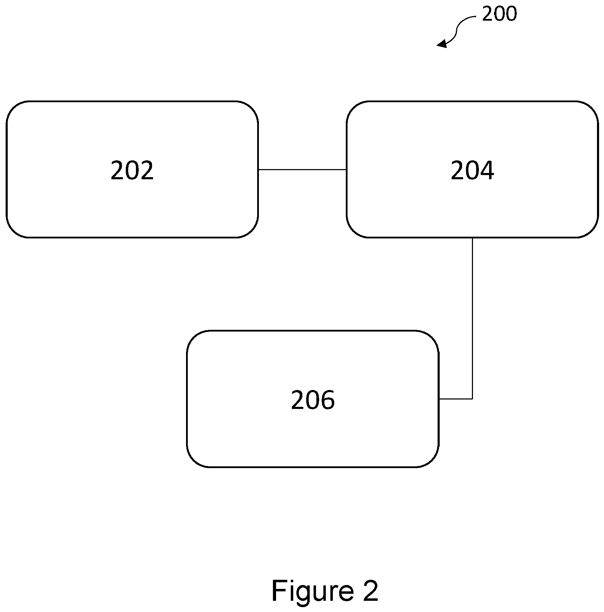

Figure 2 shows a system 200 for printing a pattern 102 using raster data 104. The system comprises a mask printing device 202, a processor 204, and a computer storage medium 206. The computer readable storage medium 206 comprises computer readable instructions which, when executed by the processor 204 having processing capability, causes the processor 204 to carry out the process as stored in the instructions. The processor 204 is provided with the vector data 100 describing the pattern 102 to be printed by the mask printing device 202. The vector data 100 is processed by the processor 204 to produce the rasterized data 104. The rasterized data 104 comprises a grid of pixels 106, corresponding to the pattern 102 to be printed. The processor 204 then defines the plurality of subsets of pixels 110 of the grid of pixels 106 in raster data 104. Each subset of pixels in the plurality of subsets of pixels 110 corresponds to a subarea of the pattern 102 to be printed. The processor 204 defines the plurality of subsets of pixels 110 such that each pixel 108 in the grid of pixels 106 is included in at least one of the subsets of pixels. In other words, it is possible to have a pixel 108 in the grid of pixels 106 to be included in more than one subset of pixels. The processor 204 further determines the pattern density data 112 using the plurality of the subsets of pixels 110 in the rasterized data 104. Pattern density data 112 is calculated for each subset of pixels based on the exposure value of the pixels 108 in the respective subset of pixels. Pattern density data 112 may correspond to the density of the patterns in the subarea of the pattern to be printed, corresponding to the subset of pixels in the mask printing device 202. The pattern density data 112 for each subset of pixels 110 may be determined as the average of the exposure values of the pixels 108 in the respective subsets of pixels 110. The storage medium 206 may also be capable of storing the vector data 100, raster data 104 and pattern density data 112. Pattern density data 112 may also be used to improve or adapt the raster data 104, to adjust for deviations in patterns, for example, variations in critical line widths, that may occur during the printing and development of photomasks due to any of the above mentioned chemical process or stray light affect.

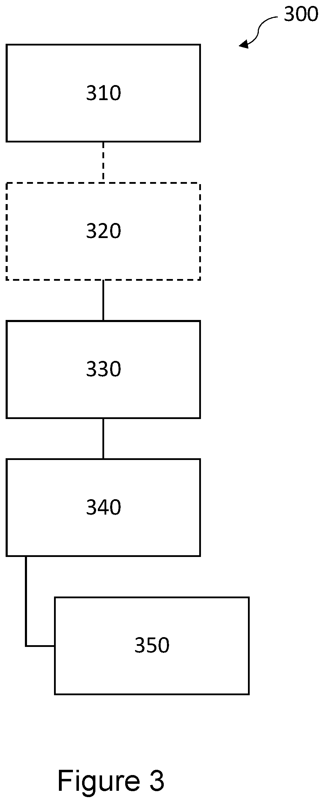

Figure 3 shows a flowchart illustrating a method 300 for determining pattern density data 112 for a pattern 102 to be printed in a mask printing device 202. In the method, vector data 100 describing the pattern 102 to be printed is received by the processor 204 in step 310. The processor 204 then rasterizes the vector data 100 to produce rasterized data 104 describing the pattern 102 to be printed in step 330. The rasterized data 104 comprise a grid of pixels 106. Each pixel in the grid of pixels 106 is associated to a respective exposure value. The vector data 100 rasterized to produce rasterized data 104 may have a resolution lower than a resolution of rasterized data required to achieve an intended exposed resolution of the pattern to be printed. In step 340, a plurality of subset of pixels 110 of the grid of pixels 106 in the raster data 104 are defined by the processor 204. The plurality of subsets of pixels 110 are defined such that each pixel 108 in the grid of pixels 106 is included in at least one of the subsets of pixels 110. In other words, it is possible to have a pixel 108 in the grid of pixels 106 to be included in more than one subset of pixels. Each subset of pixels in the plurality of subsets of pixels 110 correspond to a subarea of the pattern 102 to be printed. The step of defining the plurality of subsets of pixels 110, such that each subset of pixels may correspond to a respective rectangular subarea of the pattern to be printed. It is also possible to have all sides of the rectangular subarea having the same dimensions, i.e. the subareas each being square shaped. The plurality of subsets of pixels 110 may be further defined such that, each subset of pixels corresponds to a subarea of a printed pattern having an area in the range of 0.01 - 4 mm². Further in step 350, the processor 204 then determines the pattern density data 112 from the rasterized data 104. The pattern density data 112 is calculated for each subset of pixels of the grid of pixels 106. The density value for each subset of pixels is calculated based on the exposure values of the pixels in the respective subset of pixels. The pattern density data 112 for each subset of pixels 110 may be determined as the average i.e. mean, mode or median of the exposure values of the pixels 108 in the respective subsets of pixels 110. The obtained raster data 104 and the pattern density data 112 is then provided to the mask printing device 202 for printing of masks. The processor 204 may also correct or adapt the raster data 104 based on the calculated pattern density data 112 before sending it to the mask printing device 202. The calculated pattern density data 112 may comprise a density map.

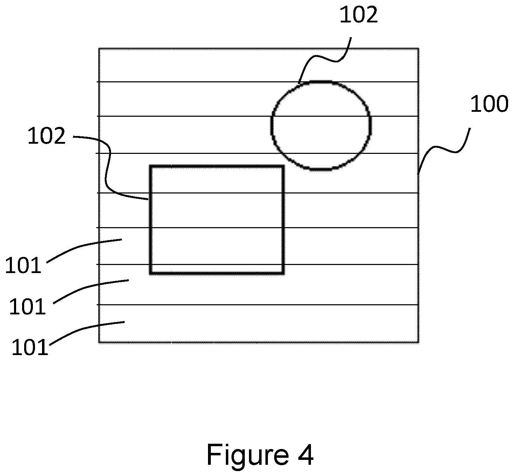

Before rasterizing the vector data 100, the processor 204 may perform an optional step 320 of dividing the vector data 100 into a number of portions of vector data 101, shown in figure 4. This process of dividing the vector data 100 into a number of portions of vector data 101 is known in the technology as fracturing. Each portion of vector data 101 describes a respective portion of the pattern 102 to be printed. In that case, the step 330 of rasterizing the vector data 100 may be performed by rasterizing each of the number of portions of vector data 101 separately to produce a corresponding number of portions of rasterized data each describing a corresponding portion of the pattern 102 to be printed. Each of the corresponding number of portions of the rasterized data comprises a respective portion of the grid of pixels, wherein each pixel is associated to a respective exposure value. Further, the step of defining a plurality of subset of pixels of the grid of pixels is defined by the processor 204 for each portion of rasterized data. Therefore, all the steps performed later in the method are performed on each portion of rasterized data in an equivalent way as mentioned above.

Fig. 5 explains how the pattern density data 112 for each of the plurality of subset of pixels 110 described in relation to Fig. 1 may be used to adjust the deviations in patterns, for example, variations in critical line widths, that may occur during the printing and development of photomasks. A global density map 502 can be computed for plurality of subsets of pixels 110 by combining the calculated pattern density map 112 for each subset of pixel. The global density map 502 may also be stated as a combination of the pattern density maps 112. This global density map 502 may be convoluted with a convolution kernel 504 to obtain a density sizing map 506. The convolution kernel describes physically the interaction length of the optical and chemical interaction, described for example by stray light and developer loading, respectively. The density sizing map 506 is therefore a physical approximation of how the pattern density will affect the printing and developing of raster data 104. The pattern density data 112 or global density map 502 or density sizing map 506 may be used to compensate for deviations in patterns, caused by previously mentioned chemical and optical effects of the pattern density of the same pattern, while printing the pattern 102 using a mask printing device 202. These types of errors are pattern-dependent errors. Another step of correction of raster data 104 may also be performed to take into account pattern-independent errors, e.g., any errors generated due to the calibration process of the system, or repeatable calibrations of the chemical development process of the photomasks, for example, deviations at the corners of the raster data in the photomask produced by the mask printing device. The obtained density sizing map 506 may then be added to a static sizing map 508 to produce a layer sizing map 510. A static sizing map is a description of repeatable pattern-independent errors in primarily photomask chemical processing. The static sizing map may also include errors due to mask writer itself or any other errors generated due to the calibration of the system, for example, deviations at the corners of the raster data in the photomask produced by the mask printing device. The layer sizing map 510 may therefore be used to adapt the deviations in patterns that may occur during the development of photomasks due to any of the pattern-independent errors, for example, calibration error of the system or device. The exposure values of the pixels 108 in the plurality of subsets of pixels 110 may be corrected by applying the density sizing map 506, or the combination of the density sizing map 506 with the static sizing map 508, i.e. the layer sizing map 510. The mask printing device 202 may be provided with the density sizing map or layer sizing map along with the raster data 104 so that the mask printing device 202 may adapt the raster data or create a new raster data for printing a pattern 102. The correction of the raster data or creation of new raster data can be performed before or while printing is in progress. The layer sizing map 510 derived from the density sizing map 506 may capture both pattern-dependent and pattern-independent errors. By correcting/ adapting the raster data or creating a new raster data, the exposure values of the pixels 108 or the size of the patterns can be corrected before or during printing of a pattern 102. It is also possible to provide the mask printing device 202 with the global density map 502 or the pattern density data 112, where an in-built processor in the mask printing device 202 may analyze and process the density data to correct or adjust any pattern deviations that may occur during printing and development of photomasks due to any of the above mentioned pattern-dependent or pattern-independent errors.

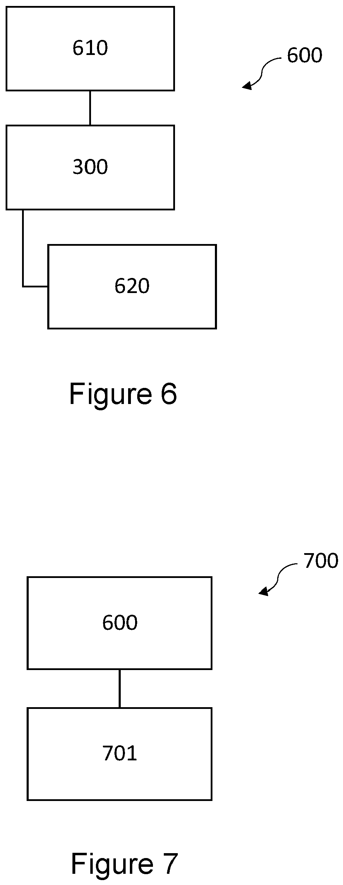

Fig. 6 shows a method 600 for deriving adapted rasterized data describing a pattern to be printed using a mask printing device. The method comprises receiving the rasterized data in step 610. Further in step 300, the method comprises determining pattern density data for the pattern according to the method as shown in relation to Fig. 3. Lastly, in step 620 deriving the adapted rasterized data describing the pattern to be printed from the received rasterized data using the determined pattern density data, i.e., the determined pattern density data is used to adapt the rasterized data to overcome any pattern-dependent errors for example due to chemical processes. Pattern-independent errors may also be used to adapt the raster data.

Fig. 7 shows a method 700 for producing a photomask according to a pattern to be printed using a mask printing device. The method comprising deriving adapted rasterized data in step 600 describing the pattern to be printed according to the method as shown in relation to Fig. 4. Thereby, producing the photomask in step 701 using the adapted rasterized data describing the pattern to be printed.

The person skilled in the art realizes that the present invention by no means is limited to the preferred embodiments described above. On the contrary, many modifications and variations are possible within the scope of the appended claims. For example, the processor performing the operations of calculating raster data, pattern density data, etc. is shown as a separate independent device from the mask printing device. However, in some of the embodiments, it is possible to have an in-built processor within a mask printing device or having multiple processors performing different tasks. Thus, the embodiments presented in the disclosure are for exemplary purpose and should not be construed as limiting the scope.

## Claims

1. A method (300) for determining pattern density data for a pattern to be printed using a mask printing device, the method comprising:
receiving (310) vector data (100) describing the pattern (102) to be printed;
rasterizing (330) the vector data to produce rasterized data (104) describing the pattern to be printed, wherein the rasterized data comprise a grid of pixels (106), wherein each pixel (108) is associated with a respective exposure value;
defining (340) a plurality of subsets of pixels (110) of the grid of pixels, wherein each subset of pixels corresponding to a subarea of the pattern to be printed; and
determining (350) the pattern density data (112) from the rasterized data, wherein the pattern density data comprises, for each subset of pixels of the grid of pixels, a density value calculated based on the exposure values of the subset of pixels.

2. The method (300) according to claim 1, wherein, in the step of determining the pattern density data, the density value is the average of the exposure values of the subset of pixels.

3. The method (300) according to any one of the previous claims, wherein, in the step of defining the plurality of subsets of pixels, each subset of pixels corresponds to a respective rectangular subarea of the pattern to be printed.

4. The method (300) of any one of the previous claims, wherein, in the step of defining the plurality of subsets of pixels, each subset of pixels corresponds to a subarea of a printed pattern having an area in the range of 0.01 - 4 mm².

5. The method (300) according to any one of the previous claims, wherein the vector data are rasterized to produce rasterized data having a resolution lower than a resolution of rasterized data required to achieve an intended exposed resolution of the pattern to be printed.

6. The method (300) according to any one of the previous claims, further comprising:
dividing (320) the vector data into a number of portions of vector data (101) each describing to a respective portion of the pattern to be printed;
wherein the step of rasterizing the vector data comprises:
rasterizing (330) each of the number of portions of vector data separately to produce a corresponding number of portions of rasterized data each describing a corresponding portion of the pattern to be printed, wherein each of the corresponding number of portions of the rasterized data comprises a respective portion of the grid of pixels, wherein each pixel is associated to a respective exposure value.

7. A method (600) for deriving adapted rasterized data describing a pattern to be printed, the method comprising:
receive (610) the rasterized data;
determining pattern density data for the pattern according to the method (300) of any of claims 1-6;
deriving (620) the adapted rasterized data describing the pattern to be printed from the received rasterized data using the determined pattern density data.

8. A computer readable storage medium comprising computer readable instructions which, when executed by a device having processing capability, causes the device to carry out the method of any of claims 1-6, or the method of claim 7.

9. A computer program comprising computer readable instructions which, when executed by a device having processing capability, causes the device to carry out the method of any of claims 1-6, or the method of claim 7.

10. A method (700) for producing a photomask according to a pattern, the method comprising:
deriving adapted rasterized data describing the pattern to be printed according to the method (600) of claim 7; and
producing (701) the photomask using the adapted rasterized data describing the pattern to be printed.

11. A computer readable storage medium comprising computer readable instructions which, when executed by a system for printing a pattern comprising a mask printing device and a processor, causes the system to carry out the method of claim 10.

12. A computer program comprising computer readable instructions which, when executed by a system for printing a pattern comprising a mask printing device and a processor, causes the system to carry out the method of claim 10.

13. A system (200) for printing a pattern, the system comprising:
a mask printing device (202),
a processor (204), and
a computer readable storage medium (206) comprising computer readable instructions which, when executed by the processor, causes the processor to carry out the method (600) of any of the claims 1-6, or the method of claim 7.
